# EUROPEAN PATENT APPLICATION

(11) **EP 4 718 979 A1**
(43) Date of publication of application: **01.04.2026**
(21) Application number: 25204208.0
(22) Date of filing: 24.09.2025
(51) Int. Cl.: H10D 30/01, H10D 30/47, H10D 62/864, H10D 64/00, H10D 62/17, H10D 62/832, H10D 62/85

(54) **SEMICONDUCTOR DEVICE AND METHOD FOR MANUFACTURING THE SAME**

(30) Priority: 26.09.2024 US 202463699227 P
(71) Applicant: ULTRABAND TECHNOLOGIES, INC., Zhubei City, Hsinchu County 302058 (TW)
(72) Inventor: WU, Chan-Shin, Zhubei City, Hsinchu County 302058 (TW)
(74) Representative: Rapisardi, Mariacristina

(57) **Abstract**

The present disclosure provides a semiconductor device (100) and a manufacturing method therefor. The semiconductor device (100) includes a substrate (102), which is an n+-type doped silicon carbide substrate, an n-type doped silicon carbide substrate, or a p-type doped silicon carbide substrate; a buffer layer (104), arranged on the substrate (102), containing a doped gallium nitride, and having a breakdown electric field of greater than or equal to 80 V/µm; an active region (M), arranged on the buffer layer (104) and including a channel layer (106) containing an undoped or unintentionally doped gallium nitride, and a barrier layer (108) arranged on the channel layer (106) and containing an undoped or unintentionally doped aluminum gallium nitride; and a source (S), a gate (G), and a drain (D), arranged on the active region (M), where the gate (G) is arranged between the source (S) and the drain (D).

## Description

### BACKGROUND OF THE INVENTION

### 1. Field of the Invention

The present disclosure relates a semiconductor device and a manufacturing method therefor, and in particular, to a semiconductor device configured as a power device and a manufacturing method therefor. However, the present disclosure is not limited thereto.

### 2. Description of the Related Art

With the rapid development and popularization of wireless communication systems and mobile devices, the demand for power devices is also increasing in the industry. Especially in the 5G infrastructure application market, excellent power devices play an important role in achieving objectives such as cost reduction, efficiency improvement, and bandwidth expansion.

In particular, high electron mobility transistors (HEMTs) using aluminum gallium nitride (AlGaN)/gallium nitride (GaN) have advantages such as low on-resistance, high current density, and high breakdown voltage, and are therefore considered as a popular technology option for power devices. These excellent properties are mainly attributed to the excellent material properties of GaN, such as wide bandgap, high critical electric field, and high electron saturation velocity. In addition, the unique polarization effect of GaN enables the AlGaN/GaN heterostructure to induce the formation of two dimensional electron gases (2DEGs) at the interface block in the undoped state, thereby enabling AlGaN/GaN HEMTs to output a high current and have a very low on-resistance.

Most of the foregoing semiconductor devices include a substrate for carrying the overall epitaxial and component structures and providing a heat dissipation path. Generally, the arrangement of the substrate not only considers its thermal conductivity and its compatibility with other layers, but also considers its crystal orientation, surface defects, and electrical properties.

### BRIEF SUMMARY OF THE INVENTION

It is found that conventional semiconductor devices, in order to improve the overall device breakdown voltage, often employ expensive semi-insulating substrates; or, while pursuing ideal electrical properties, may overlook aspects such as the crystal orientation and surface defects of the substrate. Accordingly, the present disclosure provides a technique that allows the device breakdown voltage to be dominated by the epitaxial structure, and employs relatively low-cost n+-type doped silicon carbide substrates, n-type doped silicon carbide substrates, or p-type doped silicon carbide substrates. To be specific, in the present disclosure, a particular buffer layer is arranged on the substrate of the semiconductor device to dominate the overall device breakdown voltage. Thus, according to the present disclosure, an ideal device breakdown voltage can be achieved at lower costs while ensuring the crystal orientation and surface quality of the substrate. In addition, because the breakdown voltage is dominated by the epitaxial structure, in the present disclosure, parameters of the buffer layer may also be adjusted to meet various requirements, thereby improving the design freedom of the device.

Specifically, an aspect of the present disclosure provides a semiconductor device. The device includes: a substrate, being an n+-type doped silicon carbide substrate, an n-type doped silicon carbide substrate, or a p-type doped silicon carbide substrate; a buffer layer, arranged on the substrate, containing a doped gallium nitride, and having a breakdown electric field of greater than or equal to 80 V/µm; an active region, arranged on the buffer layer, and including: a channel layer containing an undoped or unintentionally doped gallium nitride, and a barrier layer arranged on the channel layer and containing an undoped or unintentionally doped aluminum gallium nitride; and a source, a gate, and a drain, arranged on the active region, where the gate is arranged between the source and the drain.

According to some embodiments of the present disclosure, a thickness of the buffer layer is greater than or equal to 1 µm.

According to some embodiments of the present disclosure, the thickness of the buffer layer ranges from 1 to 15 µm.

According to some embodiments of the present disclosure, the semiconductor device further includes a nucleation layer, arranged between the substrate and the buffer layer, and containing an undoped or unintentionally doped aluminum nitride.

According to some embodiments of the present disclosure, a thickness of the nucleation layer is less than 100 nm.

According to some embodiments of the present disclosure, the semiconductor device further includes: a first dielectric layer, covering a part of the active region; a gate metal field plate, covering the gate and a part of the first dielectric layer; a second dielectric layer, covering the gate metal field plate and a part of the first dielectric layer; and a source metal field plate, covering a part of the source and a part of the second dielectric layer.

According to some embodiments of the present disclosure, a material of the first dielectric layer and the second dielectric layer is a nitride or an oxide.

According to some embodiments of the present disclosure, the substrate is a 4H-SiC substrate.

According to some embodiments of the present disclosure, the active region further includes a cap layer, arranged on the barrier layer, where a thickness of the cap layer ranges from 1.5 to 2.0 nm.

Another aspect of the present disclosure provides a method for manufacturing a semiconductor device. The method includes the following steps: (a) providing a substrate, where the substrate is an n+-type doped silicon carbide substrate, an n-type doped silicon carbide substrate, or a p-type doped silicon carbide substrate; (b) forming a buffer layer on the substrate, where the buffer layer contains a doped gallium nitride, and has a breakdown electric field of greater than or equal to 80 V/µm; (c) forming an active region on the buffer layer, including forming a channel layer and forming a barrier layer on the channel layer, where the channel layer contains an undoped or unintentionally doped gallium nitride, and the barrier layer contains an undoped or unintentionally doped aluminum gallium nitride; and (d) forming a source, a gate, and a drain on the active region, where the gate is arranged between the source and the drain.

According to some embodiments of the present disclosure, a thickness of the buffer layer is greater than or equal to 1 µm.

According to some embodiments of the present disclosure, a thickness of the buffer layer ranges from 1 to 15 µm.

According to some embodiments of the present disclosure, the method further includes a step (a-1) between the step (a) and the step (b): forming a nucleation layer on the substrate, where the nucleation layer contains an undoped or unintentionally doped aluminum nitride.

According to some embodiments of the present disclosure, a thickness of the nucleation layer is less than 100 nm.

According to some embodiments of the present disclosure, the method further includes the following steps: (e) forming a first dielectric layer on the active region, to cover a part of the active region; (f) forming a gate metal field plate, to cover the gate and a part of the first dielectric layer; (g) forming a second dielectric layer, to cover the gate metal field plate and a part of the first dielectric layer; and (h) forming a source metal field plate, to cover a part of the source and a part of the second dielectric layer.

According to some embodiments of the present disclosure, a material of the first dielectric layer and the second dielectric layer is a nitride or an oxide.

According to some embodiments of the present disclosure, the substrate is a 4H-SiC substrate.

According to some embodiments of the present disclosure, step (c) further includes: forming a cap layer on the barrier layer, where a thickness of the cap layer ranges from 1.5 to 2.0 nm.

In conclusion, according to the semiconductor device and the manufacturing method therefor provided in the present disclosure, an ideal device breakdown voltage can be achieved at lower costs while ensuring the crystal orientation and surface quality of the substrate. In addition, because the breakdown voltage is dominated by the epitaxial structure, in the present disclosure, parameters of the buffer layer may also be adjusted to meet various requirements, thereby improving the design freedom of the device.

### BRIEF DESCRIPTION OF THE DRAWINGS

To facilitate understanding of the foregoing and other objectives, features, advantages, and embodiments of the present disclosure, the accompanying drawings are described as follows.
FIG. 1 and FIG. 2 are each a flowchart of steps of a method for manufacturing a semiconductor device according to an embodiment of the present disclosure.
FIG. 3 is a schematic cross-sectional view of a semiconductor device according to an embodiment of the present disclosure.

According to conventional practice, various features and components in the drawings are not drawn to scale, and are drawn to best illustrate the specific features and components related to the present disclosure. In addition, the same or similar reference numerals are used to denote similar elements and components in different drawings.

### DETAILED DESCRIPTION OF THE INVENTION

To provide a more detailed and thorough description of the present disclosure, the following provides illustrative descriptions of aspects and specific embodiments of the present disclosure. However, these descriptions are not the only forms of implementing or using the specific embodiments of the present disclosure. Throughout this specification and the appended claims, unless the context indicates otherwise, the terms "a," "an," and "the" may be construed as plural. Furthermore, throughout this specification and the appended claims, unless otherwise indicated, "arranged on an object" may be construed as directly or indirectly contacting a surface of the object by attachment or other means. The definition of the surface should be determined based on the context/paragraphs of the specification and the general knowledge in the field to which the disclosure pertains.

Although the numerical ranges and parameters used to define the present disclosure are approximate, the related numerical values in the specific embodiments have been presented as accurately as possible. However, any numerical value inherently inevitably contains standard deviations due to individual testing methods. As used herein, "about" generally means that the actual value falls within ±10%, 5%, 1%, or 0.5% of a particular value or range. Alternatively, the term "about" means that the actual value falls within an acceptable standard error of the mean, as determined by those of ordinary skill in the art. Therefore, unless otherwise indicated, the numerical parameters disclosed in this specification and the appended claims are approximate and may be changed as needed. At a minimum, these numerical parameters should be understood as indicating the number of significant digits and the value obtained by applying normal rounding.

### Terms

As used herein, the term "semiconductor material" may include chemical compounds of various elements, including a pairing of Group 13 (i.e., the group including boron (B), aluminum (Al), gallium (Ga), indium (In), and thallium (Tl)) elements with Group 15 (i.e., the group including nitrogen (N), phosphorus (P), arsenic (As), antimony (Sb), and bismuth (Bi)) elements; or a pairing of Group 14 (i.e., the group including carbon (C), silicon (Si), germanium (Ge), and tin (Sn) elements, such as silicon carbide (SiC) or silicon-germanium alloys. Groups 13 to 15 may be referred to as Groups III, IV, and V, respectively.

As used herein, the term "semiconductor device" refers to an active or passive element made of a semiconductor material, including but not limited to transistors, diodes, resistors/capacitors/inductors, sensors, and arrays thereof, integrated circuits, power modules, and packages. Such transistors, such as high electron mobility transistors (HEMTs), can have a naturally normally-on structure with a negative threshold voltage, or can be converted to a normally-off structure with a positive threshold voltage.

As used herein, the term "method for manufacturing a semiconductor device" refers to any set of steps for fabricating a semiconductor device, including but not limited to: surface pretreatment, nucleation and epitaxial growth/deposition processes, patterning (including exposure/development), etching processes, lift-off processes, ion implantation/doping, annealing, alloying, passivation, packaging, and testing. Unless otherwise stated, the order, number of repetitions, and conditions of each step may be adjusted based on product design and are not intended to be limiting of the present disclosure.

As used herein, the term "epitaxial growth or deposition process" includes, but is not limited to, chemical vapor deposition (CVD), low pressure CVD (LPCVD), atmospheric pressure CVD (APCVD), ultrahigh vacuum CVD (UHVCVD), atomic layer deposition (ALD), molecular layer deposition (MLD), plasma enhanced CVD (PECVD), metal-organic CVD (MOCVD), molecular beam epitaxy (MBE), sputtering, or the like, or a combination thereof.

As used herein, the term "etching process" includes, but is not limited to, dry etching and wet etching. Dry etching includes physical bombardment methods such as reactive ion etching (RIE), inductively coupled plasma (ICP), etc. Wet etching is a chemical solution etching method well known in the art to which the present disclosure pertains.

The following description of the present disclosure provides a means for those of ordinary skill in the art to readily understand the essential technical content of the present disclosure. Various variations and modifications may be made to the present disclosure to accommodate different applications and conditions without departing from the spirit and scope of the present disclosure. Thus, other aspects also fall within the scope of the claims of the present disclosure.

### Embodiments

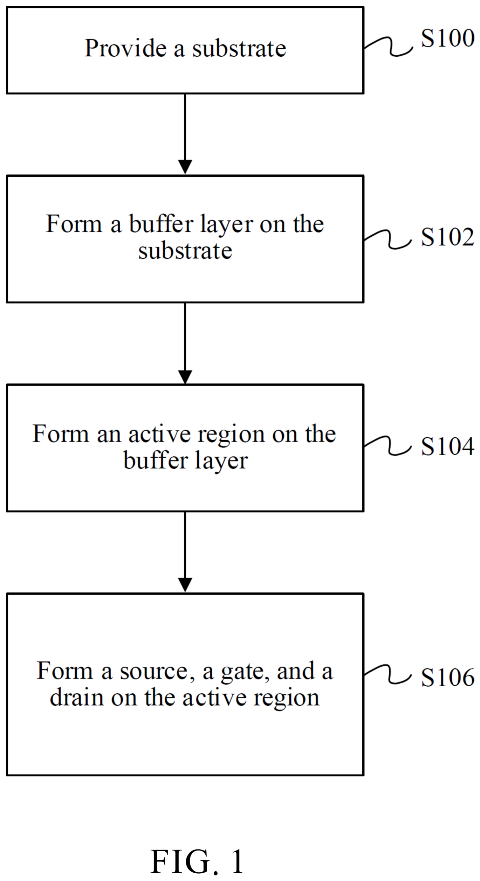

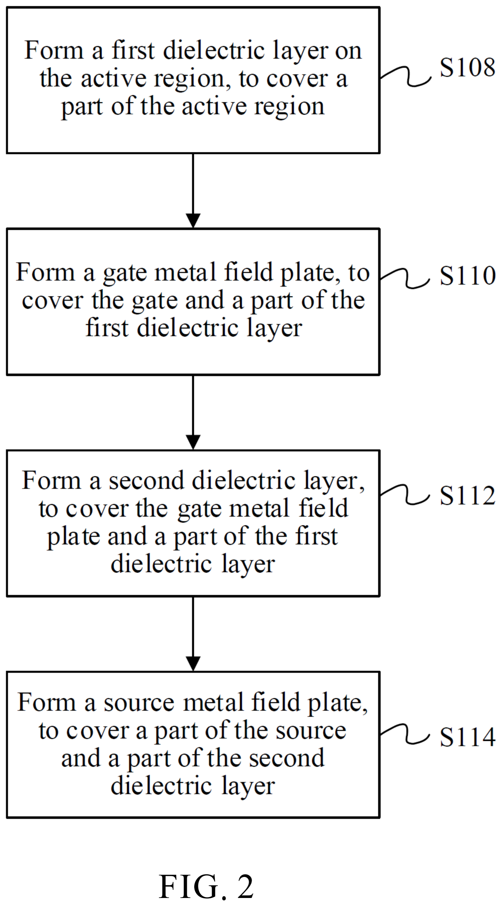

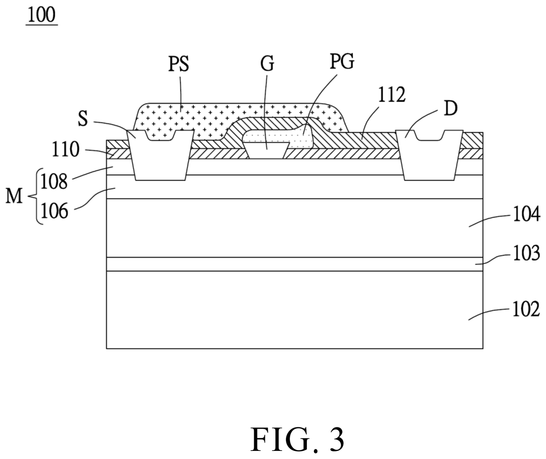

A semiconductor device and a manufacturing method therefor according to some embodiments of the present disclosure are exemplarily presented in this specification. Specifically, FIG. 1 and FIG. 2 each show a process of steps of a method for manufacturing a semiconductor device, and FIG. 3 shows a cross-sectional structure of a semiconductor device manufactured by the method.

First, referring to FIG. 1, the method for manufacturing a semiconductor device provided in the present disclosure generally includes the following steps. Step S100: Provide a substrate. Step S102: Form a buffer layer on the substrate. Step S104: Form an active region on the buffer layer. Step S106: Form a source, a gate, and a drain on the active region.

In step S100, the substrate contains a doped silicon carbide material. Without being bound by a particular theory, a substrate made of a silicon carbide material not only has good heat dissipation performance, but also has a good lattice match with a gallium nitride material. Specifically, the substrate is an n+-type doped silicon carbide substrate, an n-type doped silicon carbide substrate, or a p-type doped silicon carbide substrate. The doping type may be selected and set based on a device requirement. Preferably, the substrate is an n+-type doped silicon carbide substrate or a p-type doped silicon carbide substrate. In addition, a doping concentration of the substrate ranges from 1×10¹⁷ to 5×10¹⁹ cm⁻³, for example, is 1×10¹⁷, 5×10¹⁷, 1×10¹⁸, 5×10¹⁸, 1×10¹⁹, or 5×10¹⁹ cm⁻³, or in a range defined by any two of the above values. According to a preferred embodiment of the present disclosure, the substrate is a 4H-SiC substrate, which has an ideal crystal orientation (0 degrees, i.e., no/near-zero tilt angle) and low surface defects, making it more suitable for application in semiconductor devices.

In step S102, the buffer layer contains a doped Group III- V material. Specifically, the buffer layer contains a doped gallium nitride, and a breakdown electric field of the buffer layer is greater than or equal to 80 V/µm, for example, is 80, 90, 100, 110, 120, 130, 140, 150, 160, 170, 180, 190, 200, 210, 220, 230, 240, 250, 260, 270, 280, 290, 300, 310, 320, 330, 340, or 350 V/µm, or in a range defined by any two of the above values. Preferably, the breakdown electric field ranges from 200 to 300 V/µm, so that the device can achieve a certain breakdown voltage within an appropriate thickness. In addition, the buffer layer is formed by a suitable epitaxial growth or deposition process, and the specific process method adopted is not limited in the present disclosure.

According to some embodiments of the present disclosure, between step S100 and step S102, the method further includes: forming a nucleation layer on the substrate, to further compensate for the lattice mismatch between the substrate and the buffer layer. Specifically, the nucleation layer contains an undoped or unintentionally doped aluminum nitride, and is formed by a suitable epitaxial growth or deposition process.

In step S104, forming the active region includes forming a channel layer and forming a barrier layer on the channel layer. Specifically, the channel layer is formed by a suitable epitaxial growth or deposition process using an undoped or unintentionally doped gallium nitride as a material. The barrier layer is formed by using an undoped or unintentionally doped aluminum gallium nitride (AlₓGa₁₋ₓN) as a forming material, where x ranges from about 0.1 to about 1. According to an embodiment, x ranges from 0.15 to 1. According to another embodiment, x ranges from 0.20 to 0.25. In addition, the barrier layer is also formed by a suitable epitaxial growth or deposition process.

According to some embodiments of the present disclosure, step S104 further includes: forming a cap layer on the barrier layer, to achieve surface passivation, reduce edge leakage, and synergistically redistribute the electric field. Specifically, the cap layer may be formed by a suitable epitaxial growth or deposition process using a semiconductor material or a dielectric material.

According to some embodiments of the present disclosure, before step S106, the method may further include a preparatory process such as mesa isolation, which further includes an etching process and other steps. The etching process may be dry etching or wet etching, and preferably is dry etching, e.g., physical bombardment such as RIE, ICP, etc.

In step S106, forming the source, the gate, and the drain includes: forming a source opening, a gate opening, and a drain opening at preset positions by a suitable etching process, and then respectively forming metal layers as the source electrode, the gate electrode, and the drain electrode. A material used in the source electrode and the drain electrode is any suitable conductive material capable of forming an ohmic contact or other conductive interface. Preferably, titanium (Ti)/aluminum (Al)/nickel (Ni)/tantalum (Ta)/molybdenum (Mo)/gold (Au) may be used. A material used in the gate electrode is any conductive material capable of biasing or controlling a semiconductor device. Preferably, nickel (Ni)/gold (Au) or zirconium (Zr)/gold (Au) may be used, to generate a larger valence band energy gap with the semiconductor material used in the present disclosure. In addition, the source opening and the drain opening are etched down to the barrier layer or the channel layer, and specifically require an alloying process to alloy the metal layers formed in the openings to respectively form the source electrode and the drain electrode, and to generate ohmic contact for the semiconductor device.

Referring to FIG. 2, the method for manufacturing a semiconductor device according to the present disclosure further includes the following steps. Step S108: Form a first dielectric layer on the active region, to cover a part of the active region. Step S110: Form a gate metal field plate, to cover the gate and a part of the first dielectric layer. Step S112: Form a second dielectric layer, to cover the gate metal field plate and a part of the first dielectric layer. Step S114: Form a source metal field plate, to cover a part of the source and a part of the second dielectric layer.

In step S108, a material of the first dielectric layer is a nitride or an oxide, and the first dielectric layer is formed by a suitable epitaxial growth or deposition process. Specifically, the material of the first dielectric layer is at least one of silicon dioxide SiO₂, a silicon oxynitride SiONₓ, or a silicon nitride SiNₓ (where x ranges from about 0.1 to 1). In this way, when the first dielectric layer covers a part of the active region, the electric field distribution can be controlled to be more uniform, thereby increasing the breakdown voltage of the device and reducing leakage current. In addition, it can be further ensured that the breakdown voltage of the entire device is dominated by the epitaxial structure.

In step S110, a material of the gate metal field plate is a metal or a conductive/semiconductor thin film. Specifically, the material of the gate metal field plate is, for example, but is not limited to, aluminum, copper, a titanium/aluminum stack, a nickel/gold stack, tungsten, molybdenum, etc.

In step S112, a material of the second dielectric layer is a nitride or an oxide, and the second dielectric layer is formed by a suitable epitaxial growth or deposition process. Specifically, the material of the second dielectric layer is at least one of silicon dioxide SiO₂, a silicon oxynitride SiONₓ, or a silicon nitride SiNₓ (where x ranges from about 0.1 to 1). In this way, when the second dielectric layer covers the gate metal field plate and a part of the first dielectric layer, the electric field distribution can be controlled to be more uniform, thereby increasing the breakdown voltage of the device and reducing leakage current. In addition, it can be further ensured that the breakdown voltage of the entire device is dominated by the epitaxial structure.

In step S114, a material of the source metal field plate is a metal or a conductive/semiconductor thin film. Specifically, the material of the source metal field plate is, for example, but is not limited to, aluminum, copper, a titanium/aluminum stack, a nickel/gold stack, tungsten, molybdenum, etc. According to some other embodiments of the present disclosure, in step S114, a second gate metal field plate may be formed on the second dielectric layer, to replace the source metal field plate.

FIG. 3 is a cross-sectional view of a semiconductor device 100 according to the present disclosure. Refer to FIG. 1 to FIG. 3. According to some embodiments of the present disclosure, the semiconductor device 100 is a structure provided by a high electron mobility transistor based on aluminum gallium nitride (AlGaN)/gallium nitride (GaN), and is an epitaxially grown layer. According to some other embodiments, the semiconductor device 100 according to the present disclosure may be based on devices of other materials.

Specifically, a layer structure of the semiconductor device 100 includes, from bottom to top, a substrate 102, a nucleation layer 103, a buffer layer 104, and an active region M. The active region M includes a channel layer 106 and a barrier layer 108. Further, a source S, a gate G, and a drain D are arranged on the barrier layer. The gate G is arranged between the source S and the drain D.

According to some embodiments of the present disclosure, the semiconductor device 100 further includes: a first dielectric layer 110, which covers a part of the active region M; a gate metal field plate PG, which covers the gate G and a part of the first dielectric layer 110; a second dielectric layer 112, which covers the gate metal field plate PG and a part of the first dielectric layer 110; and a source metal field plate PS, which covers a part of the source S and a part of the second dielectric layer 112.

According to some embodiments of the present disclosure, the substrate 102 is an n+-type doped silicon carbide substrate, an n-type doped silicon carbide substrate, or a p-type doped silicon carbide substrate. Preferably, the substrate 102 is an n+-type doped silicon carbide substrate or a p-type doped silicon carbide substrate. According to a preferred embodiment of the present disclosure, the substrate 102 is a 4H-SiC substrate, which has an ideal crystal orientation (0 degrees, i.e., no/near-zero tilt angle) and low surface defects, making it more suitable for application in semiconductor devices.

According to some embodiments of the present disclosure, the buffer layer 104 contains a doped gallium nitride, and has a breakdown electric field of greater than or equal to 80 V/µm. Preferably, the breakdown electric field ranges from 200 to 300 V/µm, so that the device can achieve a certain breakdown voltage within an appropriate thickness. According to some preferred embodiments of the present disclosure, a thickness of the buffer layer 104 is greater than or equal to 1 µm. Preferably, the thickness of the buffer layer 104 ranges from 1 to 15 µm, for example, is 1.0, 1.5, 2.0, 2.5, 3.0, 3.5, 4.0, 4.5, 5.0, 5.5, 6.0, 6.5, 7.0, 7.5, 8.0, 8.5, 9.0, 9.5, 10.0, 10.5, 11.0, 11.5, 12.0, 12.5, 13.0, 13.5, 14.0, 14.5, or 15.0 µm, or in a range defined by any two of the above values. Without being bound by a particular theory, as the device breakdown voltage is dominated by the epitaxial structure, the value of the breakdown voltage approximates a product of the breakdown electric field and an effective epitaxial thickness of the material. In this way, when a buffer layer having a breakdown electric field falling within a particular range is arranged, and the thickness range of the buffer layer is limited, a required device breakdown voltage can be obtained at low costs. More specifically, if the thickness of the buffer layer 104 is configured to be excessively small, a sufficiently high device breakdown voltage cannot be obtained. If the thickness of the buffer layer 104 is configured to be excessively large, negative effects such as increased costs and complex process may be caused.

According to some embodiments of the present disclosure, a heterogeneous material interface exists between the channel layer 106 and the barrier layer 108, allowing a 2DEG region to be formed near the interface within the channel layer 106. The 2DEG region can form a conduction channel for free electrons when subjected to a bias voltage, thereby achieving the purpose of, for example, electrically coupling the source S and the drain D. Further, a material of the channel layer 106 is an undoped or unintentionally doped GaN, and a thickness of the channel layer 106 ranges from 50 to 1000 nm, for example, is 50, 100, 150, 200, 250, 300, 350, 400, 450, 500, 550, 600, 650, 700, 750, 800, 850, 900, 950, or 1000 nm, or in a range defined by any two of the above values, and preferably, ranges from 200 to 600 nm. A material of the barrier layer 108 is an undoped or unintentionally doped AlₓGa₁₋ₓN, where x ranges from about 0.1 to about 1. A thickness of the barrier layer 108 ranges from 10 to 40 nm, for example, is 10, 15, 20, 25, 30, 35, or 40 nm, or in a range defined by any two of the above values, and preferably, ranges from 10 to 20 nm.

According to a preferred embodiment of the present disclosure, the nucleation layer 103 contains an undoped or unintentionally doped aluminum nitride, to compensate for the lattice mismatch between the substrate 102 and the buffer layer 104. Specifically, a thickness of the nucleation layer 103 is less than 100 nm, for example, is 10, 20, 30, 40, 50, 60, 70, 80, 90, or 99 nm, or in a range defined by any two of the above values.

According to a preferred embodiment of the present disclosure, a cap layer (not shown in the figures) may be further provided on the barrier layer 108. A thickness of the cap layer ranges from 1.5 to 2.0 nm, for example, is 1.5, 1.6, 1.7, 1.8, 1.9, or 2.0 nm, or in a range defined by any two of the above values.

According to some embodiments of the present disclosure, the gate G is arranged on the barrier layer 108, and the source S and the drain D are respectively arranged on two sides of the gate G. Specifically, an electrode of the gate G may be any conductive material capable of biasing or controlling the semiconductor device 100. Considering the larger valence band energy gap generated by the semiconductor material used in this embodiment, the material of the gate G may preferably be nickel (Ni)/gold (Au) or zirconium (Zr)/gold (Au). An electrode of the source S and the drain D may be any suitable conductive material that can form an ohmic contact or other conductive interface with the 2DEG region, and preferably, may be titanium (Ti)/aluminum (Al)/nickel (Ni)/tantalum (Ta)/molybdenum (Mo)/gold (Au).

According to some embodiments of the present disclosure, the first dielectric layer 110 is formed on the barrier layer 108 and covers a part of the barrier layer 108, the gate metal field plate PG is formed on the gate G and a part of the first dielectric layer 110, the second dielectric layer 112 is formed on the gate metal field plate PG and a part of the first dielectric layer 110, and the source metal field plate PS is formed on a part of the source S and a part of the second dielectric layer 112. However, the sizes of the regions covered are not limited in the present disclosure. More specifically, the first dielectric layer 110 and the second dielectric layer 112 may be formed of the same or different materials, and the gate metal field plate PG and the source metal field plate PS may also be formed of the same or different materials. According to some other embodiments of the present disclosure, the source metal field plate PS may be replaced with a second gate metal field plate (not shown in the figures). Specifically, the second gate metal field plate is arranged on the second dielectric layer 112.

In conclusion, according to the semiconductor device and the manufacturing method therefor provided in the present disclosure, an ideal device breakdown voltage can be achieved at lower costs while ensuring the crystal orientation and surface quality of the substrate. In addition, because the breakdown voltage is dominated by the epitaxial structure, in the present disclosure, parameters of the buffer layer may also be adjusted to meet various requirements, thereby improving the design freedom of the device.

Although the present disclosure has been described in detail above, the detailed descriptions are merely preferred embodiments of the present disclosure, and are not intended to limit the scope of the present disclosure. Any equivalent variations and modifications that can be made by those of ordinary skill in the art without departing from the spirit and scope of the present disclosure shall fall within the protection scope of the present disclosure.

## Claims

1. A semiconductor device (100), comprising:
a substrate (102), being an n+-type doped silicon carbide substrate, an n-type doped silicon carbide substrate, or a p-type doped silicon carbide substrate;
a buffer layer (104), arranged on the substrate (102), containing a doped gallium nitride, and having a breakdown electric field of greater than or equal to 80 V/µm;
an active region (M), arranged on the buffer layer (104), and comprising: a channel layer (106) containing an undoped or unintentionally doped gallium nitride, and a barrier layer (108) arranged on the channel layer (106) and containing an undoped or unintentionally doped aluminum gallium nitride; and
a source (S), a gate (G), and a drain (D), arranged on the active region (M), wherein the gate (G) is arranged between the source (S) and the drain (D).

2. The semiconductor device (100) according to claim 1, wherein a thickness of the buffer layer (104) is greater than or equal to 1 µm.

3. The semiconductor device (100) according to claim 2, wherein the thickness of the buffer layer (104) ranges from 1 to 15 µm.

4. The semiconductor device (100) according to claim 1, further comprising a nucleation layer (103), arranged between the substrate (102) and the buffer layer (104), and containing an undoped or unintentionally doped aluminum nitride.

5. The semiconductor device (100) according to claim 4, wherein a thickness of the nucleation layer (103) is less than 100 nm.

6. The semiconductor device (100) according to claim 1, further comprising:
a first dielectric layer (110), covering a part of the active region (M);
a gate metal field plate (PG), covering the gate (G) and a part of the first dielectric layer (110);
a second dielectric layer (112), covering the gate metal field plate (PG) and a part of the first dielectric layer (110); and
a source metal field plate (PS), covering a part of the source (S) and a part of the second dielectric layer (112).

7. The semiconductor device (100) according to claim 6, wherein a material of the first dielectric layer (110) and the second dielectric layer (112) is a nitride or an oxide.

8. The semiconductor device (100) according to claim 1, wherein the substrate (102) is a 4H-SiC substrate.

9. The semiconductor device (100) according to claim 1, wherein the active region (M) further comprises a cap layer, arranged on the barrier layer (108), wherein a thickness of the cap layer ranges from 1.5 to 2.0 nm.

10. A method for manufacturing a semiconductor device (100), comprising the following steps:
(a) providing a substrate (102), wherein the substrate (102) is an n+-type doped silicon carbide substrate, an n-type doped silicon carbide substrate, or a p-type doped silicon carbide substrate;
(b) forming a buffer layer (104) on the substrate (102), wherein the buffer layer (104) contains a doped gallium nitride, and has a breakdown electric field of greater than or equal to 80 V/µm;
(c) forming an active region (M) on the buffer layer (104), comprising forming a channel layer (106) and forming a barrier layer (108) on the channel layer (106), wherein the channel layer (106) contains an undoped or unintentionally doped gallium nitride, and the barrier layer (108) contains an undoped or unintentionally doped aluminum gallium nitride; and
(d) forming a source (S), a gate (G), and a drain (D) on the active region (M), wherein the gate (G) is arranged between the source (S) and the drain (D).

11. The method according to claim 10, wherein a thickness of the buffer layer (104) is greater than or equal to 1 µm.

12. The method according to claim 10, wherein a thickness of the buffer layer (104) ranges from 1 to 15 µm.

13. The method according to claim 10, further comprising a step (a-1) between the step (a) and the step (b): forming a nucleation layer (103) on the substrate (102), wherein the nucleation layer (103) contains an undoped or unintentionally doped aluminum nitride.

14. The method according to claim 13, wherein a thickness of the nucleation layer (103) is less than 100 nm.

15. The method according to claim 10, further comprising the following steps:
(e) forming a first dielectric layer (110) on the active region (M), to cover a part of the active region (M);
(f) forming a gate metal field plate (PG), to cover the gate (G) and a part of the first dielectric layer (110);
(g) forming a second dielectric layer (112), to cover the gate metal field plate (PG) and a part of the first dielectric layer (110); and
(h) forming a source metal field plate (PS), to cover a part of the source (S) and a part of the second dielectric layer (112).

16. The method according to claim 15, wherein a material of the first dielectric layer (110) and the second dielectric layer (112) is a nitride or an oxide.

17. The method according to claim 10, wherein the substrate (102) is a 4H-SiC substrate.

18. The method according to claim 10, wherein the step (c) further comprises: forming a cap layer on the barrier layer (108), wherein a thickness of the cap layer ranges from 1.5 to 2.0 nm.
